# EUROPEAN PATENT SPECIFICATION

(11) **EP 2 056 660 B1**
(45) Date of publication and mention of the grant of the patent: **28.07.2010**
(21) Application number: 08075825.3
(22) Date of filing: 15.10.2008
(51) Int. Cl.: H05K 13/04, B23K 1/008, H05B 3/28

(54) **Heatable plate for heating a strip-shaped carrier for the purpose of fixing components to the strip-shaped carrier, as well as an oven**
Heizbare Platte zum Erhitzen einer streifenförmigen Halterung zum Zweck des Fixierens von Komponenten an der streifenförmigen Halterung sowie Herd
Plaque chauffante pour chauffer un support en forme de bande afin de fixer des composants sur le support en forme de bande, et four

(30) Priority: 30.10.2007 NL 1034606; 30.10.2007 NL 1034607
(43) Date of publication of application: 06.05.2009
(73) Proprietor: Assembléon B.V., 5503 LA Veldhoven (NL)
(72) Inventor: Wesseling, Wessel Joris, 5502 PB Veldhoven (NL)
(74) Representative: Veldman-Dijkers, Cornelia G. C.

(56) References cited:
- EP-A- 0 795 891
- DE-A1-102005 017 839
- DE-A1-102006 038 725

## Description

The invention relates to a heatable plate for heating a strip-shaped carrier for the purpose of fixing components to the strip-shaped carrier, said plate being provided with a contact surface on which the strip-shaped carrier can be positioned, which contact surface is provided with at least one opening connected to a vacuum source.

The invention further relates to an oven.

Such a heatable plate and oven are known from NL-1029954. Said patent describes a heatable plate and an oven suitable for heating a strip-shaped carrier. The components are placed in soldering compound or an adhesive or the like on the carrier, and the components are fixed to the strip-shaped carrier in the oven by causing the soldering compound to melt and subsequently solidify (a so-called "reflow soldering" process) or by curing the adhesive.

In spite of the fact that the heatable plate and oven described in the aforesaid patent produce excellent results, it has been found that the temperature of the contact surface is not uniform over the entire area thereof, which may lead to undesirable effects in certain applications.

Accordingly it is an object of the invention to provide an improved heatable plate by means of which temperature differences in the contact surface of the plate are reduced.

This object is accomplished with the heatable plate according to the invention in that the heatable plate comprises at least one edge which is at least partially bent relative to the contact surface, said edge being bent in a direction away from the strip-shaped carrier.

It has been found that the temperature differences in the contact surface are significantly reduced by using at least one bent edge. As a result of the presence of the bent edge, a more homogeneous temperature distribution over the contact surface is achieved. Said homogeneous temperature distribution leads to better results in fixing the components to the strip-shaped carrier, in particular at the edges of the contact surface near the bent edge of the plate. Because of the presence of the bent edge, the edge of the contact surface comes into less contact with relatively cold air near the bent edge. In the case of a flat plate, said relatively cold air causes the edges of the contact surface to cool down, resulting in a temperature gradient relative to the more centrally located parts of the heatable plate. Such a temperature gradient has an adverse effect on the fixation of the components to the strip-shaped carrier, for the simple reason that the soldering compound does not sufficiently heat up near the edge of the contact surface. Heating the entire plate more strongly leads to the components, in particular the components in the centre, being heated (too) strongly. In addition, this measure requires relatively much energy. Furthermore, certain components may not be heated beyond a maximum temperature.

The bent edge also gives the plate mechanical rigidity, so that it cannot deflect. Preferably, the plate is rectangular in shape and at least one of the longitudinal edges of the plate is bent. Other shapes of the heatable plate are also possible, of course.

One embodiment of the plates according to the invention is characterised in that at least one edge other than the bent edge of the plate is connected to a heating element.

The contact surface can be homogeneously heated in a simple manner by means of said edge connected to the heating element.

Another embodiment of the plates according to the invention is characterised in that an electric current can be passed through the plate by means of the heating element for heating the plate.

An especially preferred embodiment of the plate according to the invention is characterised in that the plate comprises at least two bent edges positioned opposite each other.

The more edges are bent, for example in the case of a rectangular or square plate, the more homogeneous the temperature distribution in the contact surface will be, resulting in improved results in fixing the components to the strip-shaped carrier.

Yet another embodiment of the plates according to the invention is characterised in that the heatable plate is made of a metal.

Suitable metals are stainless steel or suitable metal alloys, such as invar.

Another embodiment of the plate according to the invention is characterised in that the heatable plate is provided with at least one ceramic layer and at least one conductive layer.

A plate configured in this way is comparatively easy to produce and provides excellent results in an oven for fixing components to a strip-shaped carrier. The fact is that the heat generated in the conductive layer is excellently distributed in the ceramic layer. Besides, the ceramic material gives the plate mechanical rigidity, so that warping of the conductive layer is not possible.

Yet another embodiment of the plate according to the invention is characterised in that the upper side of the ceramic layer forms the contact surface.

As a result of the use of a conductive layer on the side remote from the strip-shaped carrier, the heat is transmitted to the ceramic layer, with the ceramic material homogeneously distributing the heat, thus achieving a homogeneous temperature distribution over the contact surface, resulting in an improved plate performance. The contact surface formed by the ceramic layer further prevents the occurrence of a short circuit between a conductor pattern on the side of the strip-shaped carrier that faces towards the plate and the conductive layer, so that it is no longer necessary to provide additional electrically insulating layers between a conductor pattern and the conductive part of the plate for preventing the occurrence of a short circuit.

Yet another embodiment of the plate according to the invention is characterised in that the conductive layer is disposed between two ceramic layers.

A plate configured in this manner is quite strong and will not deflect.

Yet another embodiment of the plate according to the invention is characterised in that the conductive layer is a metal layer.

Another object of the invention is to provide an oven by means of which temperature differences in the contact surface of a plate provided with a strip-shaped carrier are reduced.

This object is accomplished with the oven according to the invention by using a heatable plate as described above.

One embodiment of the oven according to the invention is characterised in that the oven is provided with exhaust means on the side of the strip-shaped carrier remote from the heatable plate, whilst a screening plate arranged substantially parallel to the heatable plate is provided between the strip-shaped carrier and the exhaust means.

To reduce the flow of air at the upper side of the strip-shaped carrier, exhaust means provided with a screening plate are disposed in the oven. Said screening plate causes the air to flow from the inside to the outside between the screening plate and the strip-shaped carrier, so that less fresh and thus relatively cold air is present at the upper side of the strip-shaped carrier during the aforesaid heating by means of the plate. The exhaust means in particular draw in the air from outside.

Another embodiment of the oven according to the invention is characterised in that the dimension of the screening plate corresponds to the dimension of the heatable plate.

To achieve an optimum functional effect with the air flow from the inside to the outside during a so-called "reflow soldering" process, the screeming plate has substantially the same dimensions as the plate.

The invention will now be explained in more detail with reference to the drawings, in which:
Figure 1 is a front view of a device according to the invention;
Figure 2 is a top plan view of the device shown in figure 1;
Figure 3a is a cross-sectional view of an embodiment of a plate according to the invention;
Figure 3b is a cross-sectional view of another embodiment of a plate according to the invention;
Figure 4 is a cross-sectional view of another embodiment of a plate according to the invention;
Figure 5a is a schematic view of a heatable plate in an oven according to the prior art;
Figure 5b is a schematic view of a heatable plate in an oven according to the present invention;
Figure 6 is a top plan view of a heatable plates according to the present invention,
Figures 7a and 7b show a schematic view of a configuration of heatable plate.

Like parts are indicated by the same numerals in the figures.

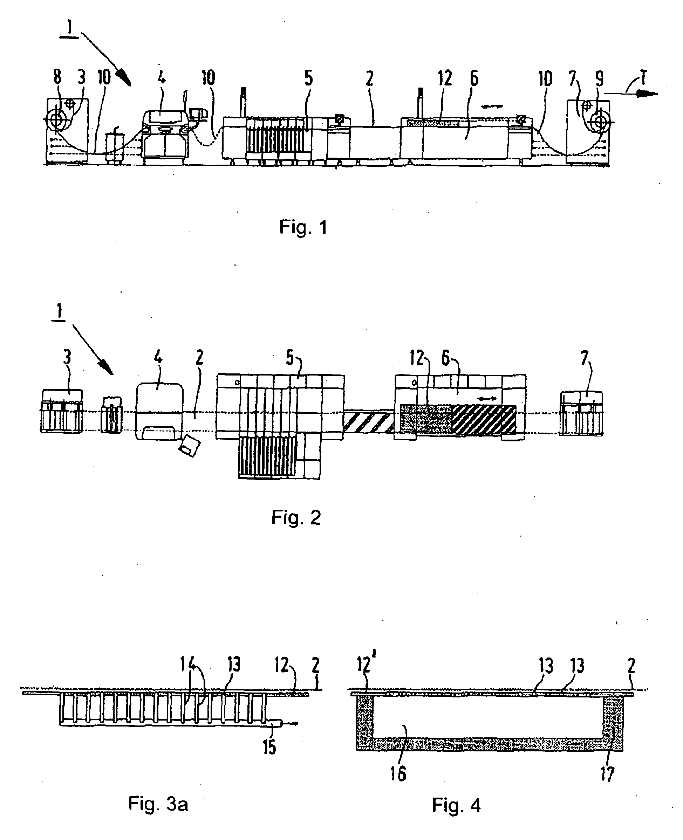

Figures 1 and 2 show a device 1 for placing and fixing electronic components to a film (strip-shaped carrier) 2, for example of polyimide, which is provided with an electrical conductor pattern. The device 1 comprises a film unwinding device 3, a stencil device 4, a component placement device 5, an oven 6, and a film winding device 7. The film 2 wound onto a roll 8 is unwound and provided with soldering compound by means of a stencil in the stencil device 4. The film 2 is then provided with components in the component placement device 5, after which the components are connected to the film 2 once the soldering compound has melted in the oven 6 and solidified again. After that, the film 2 provided with components is rolled up to a roll 9 in the film winding device 7. The film unwinding device 3, the stencil device 4, the component placement device 5 and the film winding device 7 are devices which are known per se. Buffers are provided between the various devices in the form of loops 10 in the film 2.

The oven 6 is provided with a heatable plate 12 (figures 3a, 3b, 4 and 5a, 5b), which is connected to a power source (not shown). The heatable plate 12 is provided with a number of openings 13, which are connected to pipes 14 at the bottom side. On a side facing away from the openings 13, the pipes 14 are connected to a common pipe 15, which is connected to a vacuum source (not shown) and to a blowing air source (not shown).

The plate 12 is movable in steps of a predetermined size in the conveying direction T and can also be moved back underneath the film 2 in the opposite direction of the conveying direction T. During the movement of the plate 12 in the conveying direction T, the film 2 is drawn against the plate 12 by means of a vacuum. During the movement of the plate 12 in an opposite direction of the conveying direction T, the film 2 is retained by means of a clamping mechanism, while air is at the same time blown from the openings 13 in the plate 12, so that the film 12 is clear of the plate 12.

To be able to heat the soldering compound to a sufficient extent by means of the heatable plate 12 for connecting the components to the film 2, the film 2 must have been present on the heatable plate 12 for a specific period of time.

The temperature of the plate 12 can be readily controlled by means of the electric current that is to be passed through the plate 12, thus making it possible to effect a desired heating and cooling curve of the film 2. The temperature of the plate 12 is measured by means of thermo-elements (not shown). A matrix of thermo-elements may be provided for monitoring and possibly adjusting the temperature distribution in the plate 12.

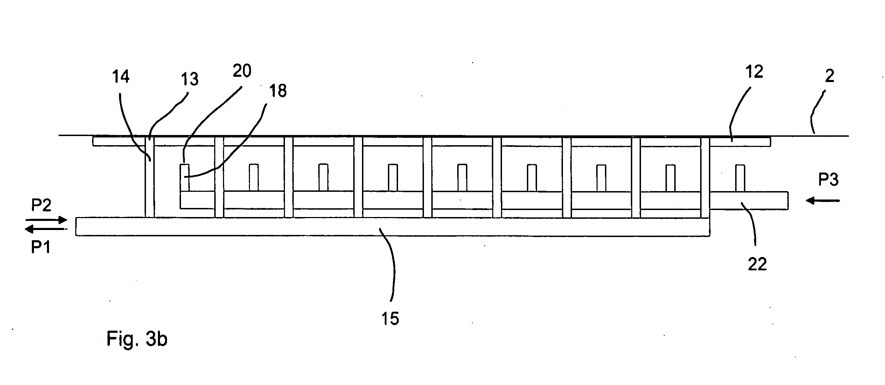

Instead of generating a vacuum by means of the pipes 14 via the openings 13 (as indicated by the arrow P1 in figure 3), it is also possible to blow air through the common pipe 15 in the direction indicated by the arrow P2 by means of the blowing air source for the purpose of cooling the heating plate 12 and in particular for "lifting" the film 2 from the plate 12, so that it can be moved. The pipes 14 may also be individually connected either to a vacuum source or to a blowing air source.

A special preferred embodiment is furthermore shown in figure 3b, in which embodiment the pipes 14 are alternated with shorter pipes 18, whose openings 20 end under the plate 12 on the side remote from the film 2, via which openings cooling air from a cooling air source (not shown) is blown through a pipe 22 in the direction indicated by the arrow P3 against the underside of the plate 12, so that the plate 12 can be forcibly cooled.

Figure 4 shows a second embodiment of the heatable plate 12', which is provided with openings 13. The plate 12' is disposed about a chamber 17 defining a space 16, which space 16 is connected to a vacuum source. Such a chamber 17 is of relatively simple construction.

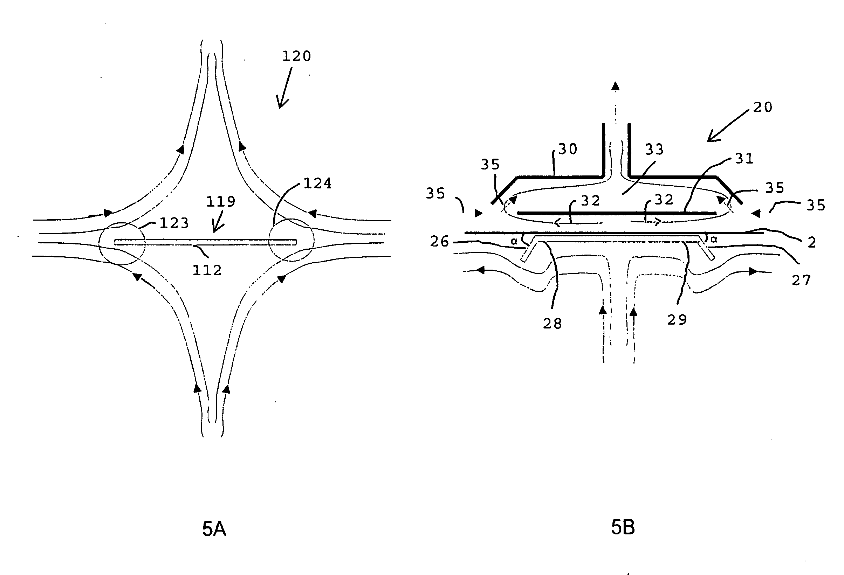

Figures 5a and 5b show the air flows along the film 2 in the case of a known, flat heatable plate 12 (figure 5a) and in the case of a curved heatable plate 12 according to the present invention in an oven 20 provided with exhaust means 21 (figure 5b).

The air flows are indicated by means of arrows in figures 5a and 5b. In figure 5a, substantially the entire plate 112 forms a contact surface 119 for the film 2. Consequently, the entire contact surface 112 is heated by means of the plate 112 for the purpose of heating the film 2. The edges 123, 124 of the heatable plate 112 are encircled, and in a conventional oven a relatively cold air flow streams close to said edges 123, 123 of the contact surface. Said air flow strongly cools down the edges. Because the edges are cooled down, a temperature difference develops between parts located in the centre and the edges 123, 124 of the contact surface. The occurrence of said temperature differences during the "reflow soldering" process is undesirable, because on the one hand either too much energy is put into the plate 112 for heating the edges 123, 124 of the contact surface to the correct temperature, with the centre of the plate 112 having a temperature that is too high, or, on the other hand, the temperature of the edges 123, 124 of the contact surface is too low, as a result of which the components are not correctly fixed to the film 2. In addition, the temperatures must not rise too high in the centre of the plate 112 because of the presence of the electrical components, because the risk of the components breaking down is too great in the case of a high temperature.

To avoid these problems, the plate 12, 12' according to the present invention is provided with bent edges 26, 27. The angle of bend is preferably an acute angle, for example an angle of 45°. The bent edges 26, 27 are connected to the edges 28, 29 of the contact surface. As a result of the presence of the bent edges 26, 27, the relatively cold air flows close to the edges 28, 29 of the contact surface. This relatively simple measure leads to a more homogeneous temperature profile of the contact surface 19 of the plate 12, 12', which provides good results upon fixing the components to the cylinder 2, also at the edges 28, 29 of the contact surface, whilst furthermore this measure does not require an increased energy supply.

The oven 20 is further provided with a screening plate 31, above which an exhaust duct 33 of the exhaust means 13 is located. The exhaust means 13 are provided in the oven 20 for reducing the relatively cold air flow at the upper side of the film 2. The screening plate 31 extending parallel to the contact surface 19 of the plate 12, 12' causes the air to flow from the inside to the outside between the screening plate 31 and the film 2 (as is indicated by means of the arrows 32 in figure 5b), so that less fresh air and thus less relatively cold air will be present at the upper side of the film 2 during the heating thereof by means of the plate 12, 12'. The exhaust means 13 are used in particular for drawing in air from outside, as indicated by means of the arrows 35.

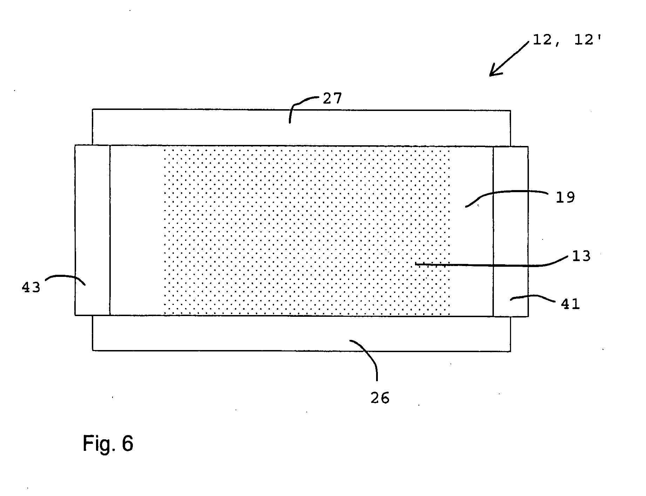

Figure 6 is a top plan view of the heatable plate 12, 12' according to the present invention. Said rectangular plate 12, 12' has two bent or flanged edges 26, 27, as well as two opposite electrode connections 41, 43 for heating the plate 12, 12'.

The contact surface 19 is formed by the substantially flat part of the heatable plate 12, 12'.

The bent edges 26, 27 give the plate 12, 12' an improved mechanical strength.

Especially in the case of the embodiment shown in figure 4 said improved mechanical strength prevents undesirable deflection of the plate 12 under the influence of the vacuum in the chamber 17.

It is also possible to provide additional heating means in the oven 6, by means of which the film 2 is heated from an upper side.

Instead of heating a soldering compound it is similarly also possible to cure an adhesive.

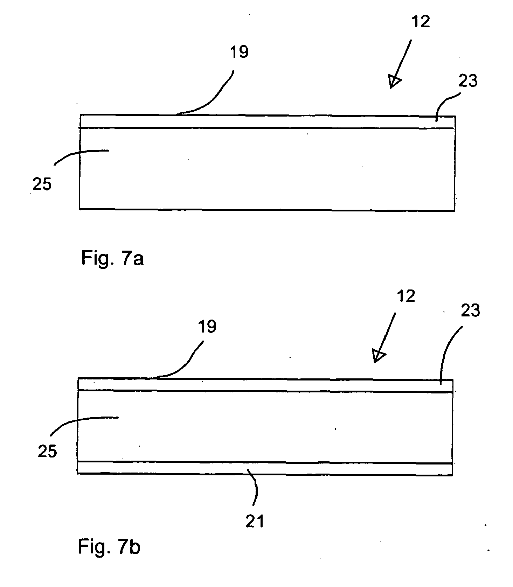

Figures 7a and 7b show a schematic view of a configuration of heatable plate 12. The heatable plate is indicated in the text below and in figures 7a and 7b with reference number 12, but the configuration shown is also applicable on plate 12'.

The heatable plate 12 shown in figure 7a comprises a ceramic layer 23 and an electric current conductive layer 25. As known, ceramic material is an excellent heat conductor. By means of the ceramic layer 23, heat generated in the conductive layer 25 can be distributed perfectly over contact surface 19. The electric current conductive layer 25 is preferably a metal layer 25. The contact surface 19 will have homogeneous temperature profile by means of the ceramic material, which has a positive effect on mounting components to the carrier 2.

Further, the ceramic layer 23 gives the plate 12, 12' an improved mechanic strength. This is particular an advantage for plate 12', as the space 16 provides to the plate 12 a slight tendency to deflection. By providing a ceramic layer 23 serving as a contact surface 19 with the film 2, conductive layer 25 is electrically separated from film 2, preventing the occurrence of a short circuit between film 2 and the conductive layer 25.

Figure 5b shows a heatable plate 12 comprising two ceramic layers 21, 23 between which a conductive layer is provided. Contact surface 19 is provided by ceramic layer 23. By means of said conductive layer 25, the contact surface 19 is homogeneously heated. By providing two ceramic layers 21, 23 having a conductive layer 23 there between, a plate 12, 12' is provided having a relatively high mechanic strength, which plate 12 during use hardly can deflect.

Preferably, the conductive layer 23 is thicker than the ceramic layer(s) 23, 25.

## Claims

1. A heatable plate for heating a strip-shaped carrier for the purpose of fixing components to the strip-shaped carrier, said plate being provided with a contact surface on which the strip-shaped carrier can be positioned, which contact surface is provided with at least one opening connected to a vacuum source, **characterised in that** the heatable plate comprises at least one edge which is at least partially bent relative to the contact surface, said edge being bent in a direction away from the strip-shaped carrier.

2. A heatable plate according to claim 1, **characterised in that** at least one edge other than the bent edge of the plate is connected to a heating element.

3. A heatable plate according to claim 2, **characterised in that** an electric current can be passed through the plate by means of the heating element for heating the plate.

4. A heatable plate according to any one of the preceding claims, **characterised in that** the plate comprises at least two bent edges positioned opposite each other.

5. A heatable plate according to any one of the preceding claims, **characterised in that** the heatable plate is made of a metal.

6. A heatable plate according to any one of the preceding claims 1-4, **characterised in that** the heatable plate is provided with at least one ceramic layer and at least one conductive layer.

7. A heatable plate according to claim 6, **characterised in that** the upper side of the ceramic layer forms the contact surface.

8. A heatable plate according to either one of the preceding claims 6 or 7, **characterised in that** the conductive layer is disposed between two ceramic layers.

9. A heatable plate according to any one of the preceding claims 6-8, **characterised in that** the conductive layer is a metal layer.

10. An oven for heating a strip-shaped carrier for the purpose of fixing components to the strip-shaped carrier, comprising a heatable plate according to any one of the preceding claims.

11. An oven according to claim 10, **characterised in that** the oven is provided with exhaust means on the side of the strip-shaped carrier remote from the heatable plate, whilst a screening plate arranged substantially parallel to the heatable plate is provided between the strip-shaped carrier and the exhaust means.

12. An oven according to claim 11, **characterised in that** the dimension of the screening plate corresponds to the dimension of the heatable plate.

## Patentansprüche

1. Heizbare Platte zum Erhitzen einer streifenförmigen Halterung zum Zweck des Fixierens von Komponenten an der streifenförmigen Halterung, wobei die Platte mit einer Kontaktfläche, auf der die streifenförmige Halterung positioniert werden kann, versehen ist, wobei die Kontaktfläche mit wenigstens einer mit einer Vakuumquelle verbundenen Öffnung versehen ist, **dadurch gekennzeichnet, dass** die heizbare Platte mindestens eine Kante aufweist, die relativ zur Kontaktfläche abgewinkelt ist, und zwar in einer von der streifenförmigen Halterung hinweg weisenden Richtung.

2. Heizbare Platte nach Anspruch 1, **dadurch gekennzeichnet, dass** mindestens eine andere Kante als die abgewinkelte Kante der Platte mit einem Heizelement verbunden ist.

3. Heizbare Platte nach Anspruch 2, **dadurch gekennzeichnet, dass** zum Heizen der Platte ein elektrischer Strom mittels des Heizelements durch die Platte geleitet werden kann.

4. Heizbare Platte nach einem der vorangehenden Ansprüche, **dadurch gekennzeichnet, dass** die Platte mindestens zwei sich gegenüber liegende abgewinkelte Kanten umfaßt.

5. Heizbare Platte nach einem der vorangehenden Ansprüche, **dadurch gekennzeichnet, dass** sie aus einem Metall hergestellt ist.

6. Heizbare Platte nach einem der vorangehenden Ansprüche 1-4, **dadurch gekennzeichnet, dass** sie mit mindestens einer keramischen Schicht und mit mindestens einer leitfähigen Schicht versehen ist.

7. Heizbare Platte nach Anspruch 6, **dadurch gekennzeichnet, dass** die obere Seite der Keramikschicht die Kontaktfläche bildet.

8. Heizbare Platte nach einem der beiden vorangehenden Ansprüche 6 oder 7, **dadurch gekennzeichnet, dass** die leitfähige Schicht zwischen zwei Keramikschichten angeordnet ist.

9. Heizbare Platte nach einem der vorangehenden Ansprüche 6-8, **dadurch gekennzeichnet, dass** die leitfähige Schicht eine Metallschicht ist.

10. Herd zum Erhitzen einer streifenförmigen Halterung zum Zweck des Fixierens von Komponenten an der streifenförmigen Halterung, umfassend eine heizbare Platte nach einem der vorangehenden Ansprüche.

11. Herd nach Anspruch 10, **dadurch gekennzeichnet, dass** er auf der von der heizbaren Platte entfernten Seite der streifenförmigen Halterung mit Mitteln zur Entlüftung und/oder Absaugung versehen ist, während zwischen der streifenförmigen Halterung und den Mitteln zur Entlüftung und/oder Absaugung parallel zur heizbaren Platte eine Abschirmplatte angeordnet ist.

12. Herd nach Anspruch 11, **dadurch gekennzeichnet, dass** die Abmessung der Abschirmplatte der Abmessung der heizbaren Platte entspricht.

## Revendications

1. Plaque chauffante pour le chauffage d'un support en forme de bande afin de fixer des composants au support en forme de bande, ladite plaque étant pourvue d'une surface de contact sur laquelle le support en forme de bande peut être placé, cette surface de contact étant pourvue d'au moins une ouverture reliée à une source de vide, **caractérisée en ce que** la plaque chauffante comprend au moins un bord qui est au moins partiellement incurvé par rapport à la surface de contact, ledit bord étant incurvé dans une direction opposée au support en forme de bande.

2. Plaque chauffante selon la revendication 1, **caractérisée en ce qu'**au moins un bord autre que le bord incurvé de la plaque est relié à un élément chauffant.

3. Plaque chauffante selon la revendication 2, **caractérisée en ce qu'**un courant électrique peut être envoyé à travers la plaque au moyen de l'élément chauffant pour chauffer la plaque.

4. Plaque chauffante selon l'une quelconque des revendications précédentes, **caractérisée en ce que** la plaque comprend au moins deux bords incurvés placés à l'opposé l'un de l'autre.

5. Plaque chauffante selon l'une quelconque des revendications précédentes, **caractérisée en ce que** la plaque chauffante est constituée d'un métal.

6. Plaque chauffante selon l'une quelconque des revendications précédentes 1 à 4, **caractérisée en ce que** la plaque chauffante est pourvue d'au moins une couche céramique et d'au moins une couche conductrice.

7. Plaque chauffante selon la revendication 6, **caractérisée en ce que** le côté supérieur de la couche céramique forme la surface de contact.

8. Plaque chauffante selon l'une ou l'autre des revendications précédentes 6 ou 7, **caractérisée en ce que** la couche conductrice est disposée entre deux couches céramiques.

9. Plaque chauffante selon l'une quelconque des revendications précédentes 6 à 8, **caractérisée en ce que** la couche conductrice est une couche métallique.

10. Four pour le chauffage d'un support en forme de bande afin de fixer des composants au support en forme de bande, comprenant une plaque chauffante selon l'une quelconque des revendications précédentes.

11. Four selon la revendication 10, **caractérisé en ce que** le four est pourvu d'un dispositif d'évacuation situé sur le côté du support en forme de bande qui est éloigné de la plaque chauffante, tandis qu'une plaque formant écran disposée de manière sensiblement parallèle à la plaque chauffante est prévue entre le support en forme de bande et le dispositif d'évacuation.

12. Four selon la revendication 11, **caractérisé en ce que** la dimension de la plaque formant écran correspond à la dimension de la plaque chauffante.
